# EUROPEAN PATENT SPECIFICATION

(11) **EP 1 876 873 B1**
(45) Date of publication and mention of the grant of the patent: **27.07.2011**
(21) Application number: 06732461.6
(22) Date of filing: 28.04.2006
(51) Int. Cl.: H05K 3/00, B32B 15/088, H05K 1/03

(54) **PROCESS FOR PRODUCING DOUBLE-SIDED FLEXIBLE PRINTED BOARD AND DOUBLE-SIDED FLEXIBLE PRINTED BOARD**
PROZESS ZUR HERSTELLUNG EINER DOPPELSEITIGEN FLEXIBLEN LEITERPLATTE UND DOPPELSEITIGE FLEXIBLE LEITERPLATTE
CARTE DE CIRCUIT IMPRIME SOUPLE A DOUBLE FACE ET SON PROCEDE DE FABRICATION

(30) Priority: 28.04.2005 JP 2005131794
(43) Date of publication of application: 09.01.2008
(73) Proprietor: NIPPON KAYAKU KABUSHIKI KAISHA, Tokyo 102-8172 (JP)
(72) Inventor: AKATSUKA, Yasumasa, Sanyoonoda-shi, Yamaguchi 7578686 (JP); MOTEKI, Shigeru NIPPON KAYAKU K. K., Kita-ku, Tokyo 1150042 (JP); UCHIDA, Makoto, NIPPON KAYAKU K. K., Kita-ku, Tokyo 1150042 (JP); ISHIKAWA, Kazunori, Fukuyama-shi, Hiroshima 721856 (JP)
(74) Representative: Gille Hrabal Struck Neidlein Prop Roos
(86) International application number: PCT/JP2006/308958
(87) International publication number: WO 2006/118239

(56) References cited:
- EP-A- 1 300 444
- EP-A- 1 333 077
- WO-A-2004/048436
- JP-A- 3 164 241
- JP-A- 4 188 792
- JP-A- 03 164 241
- JP-A- 61 245 868
- JP-A- 2001 081 282

## Description

### Technical field

The present invention relates to a process for producing a double-sided flexible printed board having sufficient heat resistance through simple production steps without necessitating a complicated apparatus.

### Background

A flexible printed board is a flexible wiring plate in which a conductor circuit is formed on the surface of a polymer insulating film. The flexible printed board has been abundantly used as a means for attaining the miniaturization and high-density of electronic apparatuses in recent years. Particularly, the flexible printed board using aromatic polyimide as the insulating film occupies the mainstream. Since a conventional flexible printed board was produced by a process in which a polyimide film was applied to a copper foil using an adhesive, physical properties such as heat resistance, noncombustibility, electrical property and adhesion were influenced by the adhesive used, resulting in that various excellent characteristics of polyimide were not sufficiently exhibited. As a means for solving this problem, a process comprising directly applying a varnish of polyamic acid (precursor of polyimide) on a metal foil, removing a solvent and curing the varnish has been performed (Japanese Patent Application Laying Open (KOKAI) No. 61-245868). Recently, because of the increased density of the board, a double-sided flexible board in which copper foils have been applied to both sides of a polyimide film has been increasingly required. In the case of this double-sided flexible printed board, a typical process in which a thermoplastic polyimide or the like is applied to the above single-sided flexible printed board and a copper foil is laminated using high heat has been proposed. Also, WO 02/00791 or WO 2004/048436 describes that an adhesive layer for bonding the polyimide film to the metal foil may be used as an insulating film without using the polyimide films. JP 03 164 241 A discloses a metal foil double-clad laminate obtained by coating a metal foil with a solution containing a polyimide resin and/or a polyamideimide resin. EP 1 333 077 A1 discloses a varnish for flexible printed wiring boards, the varnish containing an aromatic polyamide resin containing a phenolic hydroxyl group.

### Disclosure of the invention

### Problems to be solved in the invention

In the case of a single-sided flexible printed board, the problems of the above mentioned reductions of various characteristics caused by the adhesive can be solved by directly applying the varnish of polyamic acid (precursor of polyimide) onto the metal foil, removing the solvent, and curing the varnish. However, heat-curing of polyamic acid usually requires heating of polyamic acid at a high temperature of 250 to 350°C for 2 to 5 hours, and the process has the problem in view of the productivity. Also, since the curing shrinkage is large in the condensation process of polyamic acid, the produced flexible printed board is curled so much that it is problematic. In the case of production of a double-sided flexible printed board, in addition to the difficulty in the production of the single-sided flexible printed board, it is necessary to use a thermoplastic polyimide, requiring a large-scale apparatus for heating and melting the thermoplastic polyimide of which melting point is usually as high as 200°C or more.

### Means for solving the problems

Under the above situations, the inventors have earnestly studied to obtain a double-sided flexible board in which shrinkage of the board in curing is low and a long time curing process at a high temperature is not required, resulting in completion of the invention.

That is, the present invention provides the following items 1 to 3.
1. A process for producing a double-sided flexible printed board comprising the steps of:
   directly applying a varnish comprising an aromatic polyamide resin represented by the following formula (1), an epoxy resin, and an organic solvent to a metal foil,
   removing the solvent to form a resin layer, and
   applying another metal foil on the resin layer side and curing the resin layer, 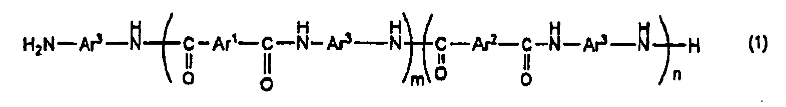 in the formula (1), m and n are average values, m+n is a positive number of 2 to 200, n is a positive number of 0.1 or larger;
      Ar¹ is a divalent aromatic group;
      Ar² is a divalent aromatic residue having a phenolic hydroxy group; and
      Ar³ is selected from the group consisting of the formula (3) 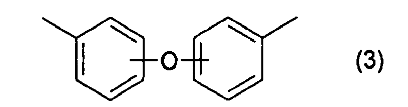 and the formula (4): 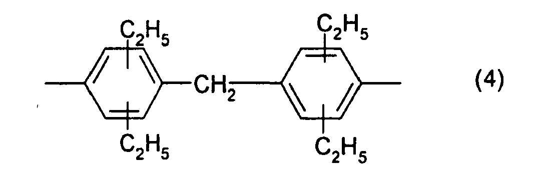 according to the above item (1)
2. A double-sided flexible printed board produced by the process according to the above item (1).
3. A double-sided flexible printed board consisting of three layers, wherein the three-layers consists of an insulating layer comprising an aromatic polyamide resin having a phenolic hydroxy group represented by the formula (1) in the above item (1) and an epoxy resin, and metal foils provided on both sides of the insulating layer.

### Detailed description of the invention

The production process of the present invention is simple and economically excellent, because it does not require a large-scale apparatus. The double-sided flexible board obtained according to the present invention is extremely advantageous in industrial view points, because it can be produced under general conditions for

epoxy resin curing, while maintaining heat resistance and noncombustibility resembling the case where polyimide is used.

Examples of metal foils used in the present invention include copper, aluminum, iron, gold, silver, nickel, palladium, chromium, molybdenum, and an alloy thereof. The metal foil may be subjected to a mechanical or chemical surface treatment of corona discharge, sanding, plating, aluminum alcoholate, aluminum chelate, and a silane coupling agent or the like, in order to enhance adhesion between the metal foil and a resin layer. Of these, the copper foil is particularly preferable. The copper foil may be an electrolytic copper foil or a rolled copper foil. The metal foil typically has a thickness of 3 to 50 µm, preferably 4 to 40 µm.

The aromatic polyamide resin used in the present invention is represented by the following formula (1) Such aromatic polyamide resins can be prepared according to the process described in, for example, the publication of Japanese Patent Application Laying Open (KOKAI) No. 8-143661 or the like. 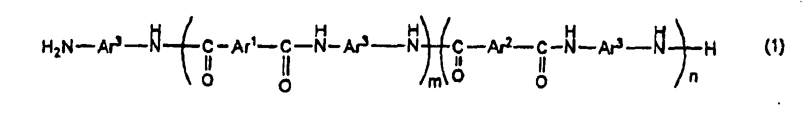
in the formula (1), m and n are average values, m+n is a positive number of 2 to 200, n is a positive number of 0.1 or larger;
Ar¹ is a divalent aromatic group;
Ar² is a divalent aromatic residue having a phenolic hydroxy group; and
Ar³ is selected from the group consisting of the formula (3) 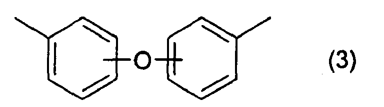
and the formula (4):

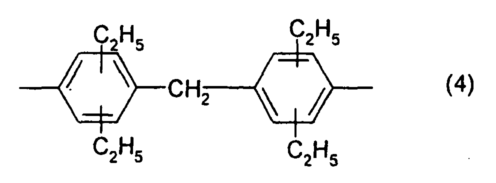

Hereinafter, a method for producing the aromatic polyamide resin used in the present invention will be described. The polyamide resin represented by the formula (1) can be produced by feeding the aromatic diamine in an amount excessive in molar ratio to the aromatic dicarboxylic acid, followed by polymerization-condensation. The polymerization-condensation reaction of the aromatic carboxylic acid and the aromatic diamine is preferably carried out in the presence of an aromatic phosphite and a pyridine derivative as condensing agents.

Examples of the aromatic phosphites used herein include triphenyl phosphite, diphenyl phosphite, tri-o-tolyl phosphite, di-o-tolyl phosphite, tri-m-tolyl phosphite, di-m-tolyl phosphite, tri-p-tolyl phosphite, di-p-tolyl phosphite, and tri-p-chlorophenyl phosphite. The amount of the aromatic phosphite to be used is, per 1 mol of the aromatic diamine, typically 0.5 to 3 mol and preferably 1 to 2.5 mol.

Examples of the pyridine derivatives include pyridine, 2-picoline, 3-picoline, 4-picoline, 2,4-lutidine, 2,6-lutidine, and 3,5-lutidine. The amount of the pyridine derivative to be used is, per 1 mol of the aromatic diamine, typically 1 to 5 mol and preferably 2 to 4 mol.

Examples of the aromatic diamines to be used for producing the above aromatic polyamide resin include diaminobenzene, diaminotoluene, diaminophenol, diaminomethylbenzene, diaminomesitylene, diaminochlorobenzene, diaminonitrobenzene, diaminoazobenzene, diaminonaphthalene, diaminobiphenyl, diaminodimethoxybiphenyl, diaminodiphenylether, diaminodimethyldiphenylether, methylenedianiline, methylenebis(methoxyaniline), methylenebis(dimethoxyaniline), methylenebis(ethylaniline), methylenebis (diethoxyaniline), methylenebis(ethoxyaniline), methylenebis(diethoxyaniline), methylenebis(dibromoaniline), isopropylidenedianiline, hexafluoroisopropylidenedianiline, diaminobenzophenone, diaminodimethylbenzophenone, diaminoanthraquinone, diaminodiphenylthioether, diaminodiphenylsulfoxide, and diaminofluorene. Among them, diaminodiphenylether and methylenebis(diethylaniline) are the aromatic diamines to be used for producing the aromatic polyamide resin according to the process of the invention.

Examples of the aromatic dicarboxylic acids to be used for producing the above aromatic polyamide resin include aromatic dicarboxylic acids having no phenolic hydroxy group such as phthalic acid, isophthalic acid, terephthalic acid, benzenediacetic acid, benzenedipropionic acid, biphenyldicarboxylic acid, oxydibenzoic acid, thiodibenzoic acid, dithiodibenzoic acid, dithiobis(nitrobenzoic acid), carbonyldibenzoic acid, sulfonyldibenzoic acid, naphthalenedicarboxylic acid, methylenedibenzoic acid, isopropylidenedibenzoic acid, hexafluoroisopropylidene benzoic acid and pyridinedicarboxylic acid, and aromatic dicarboxylic acids having a phenolic hydroxy group such as hydroxyisophthalic acid, hydroxyterephthalic acid, dihydroxyisophthalic acid and dihydroxyterephthalic acid. Since the aromatic polyamide resin acts as a curing agent for an epoxy resin in the present invention, the aromatic polyamide is needed to have the phenolic hydroxy group. In order to obtain such aromatic polyamide resins, the aromatic dicarboxylic acids having the phenolic hydroxy group is used in an amount of 1 mol% or more of the total content of the aromatic dicarboxylic acids.

In the reaction, inorganic salts are preferably used as catalysts for easy progress of the reaction. Specific examples of the inorganic salts include lithium chloride, calcium chloride, sodium sulfate, and a mixture thereof The amount of these inorganic salts to be used is, per 1.0 mol of the compound of the formula (5) or formula (I) to be used, typically 0.1 to 2.0 mol and preferably 0.2 to 1.0 mol.

The solvent to be used in the production of the aromatic polyamide resin is not critical as long as the solvent produces a solvate with the aromatic polyamide resin. Specific examples of the solvents include N,N-dimethylformamide, N,N-dimethylacetamide, N-methyl-2-pyrolidone, dimethyl sulfoxide, and a mixed solvent thereof N-methyl-2- pyrolidone is particularly preferable. The concentration of the aromatic polyamide resin in the solution is preferably 2 to 50% by weight and particularly preferably 5 to 30% by weight for efficient production and easy operation as to the viscosity of the solution.

In the production of the aromatic polyamide resin, water is dropped into the reaction system after the termination of the condensation reaction. The water is added under stirring typically at 60 to 110°C and preferably at 70 to 100°C. The amount of the water to be added is, relative to the total weight of a reaction solution, typically 10 to 200% by weight and preferably 20 to 150% by weight.

The time for dropping the water is typically 30 minutes to 15 hours and preferably 1 to 10 hours. During the water-dropping step, the remaining condensing agent is hydrolyzed to phosphate ions and a phenol. The dropping of the water is continued under stirring until a resin layer and an aqueous layer begin to separate.

When the layers begin to separate, the stirring is stopped, and the reaction solution is left at rest to separate the upper layer (aqueous layer) from the lower layer (resin layer). The upper aqueous layer is removed. Since the resin layer is typically a slurry having high viscosity, the aqueous layer can be easily removed by decantation or the like. The aqueous layer can be also removed out of the system by a pump or the like. The aqueous layer contains impurities and some of the solvent, such as phosphoric acid, phosphorous acid, catalysts, phenols and pyridines.

Some parts of the solvent were removed in the remaining resin layer in which the aqueous layer was removed, and the remaining resin layer became considerably viscous and difficult to be handled. Therefore, the resin layer is diluted with an organic solvent. Examples of the organic solvent which can be used in this step include N,N-dimethylformamide, N,N-dimethylacetamide, N-methyl-2-pyrolidone, and dimethyl sulfoxide. The amount of the solvent to be used is not critical as long as the viscosity is sufficiently reduced, and is, relative to the weight of the reaction solution before washing, typically 5 to 100% by weight and preferably 10 to 80% by weight.

By repeating the washing step typically 1 to 10 times and preferably 2 to 8 times, a treated solution of the aromatic polyamide resin with reduced ionic impurities and low molecular weight organic impurities is obtained.

The washing /dilution-treated solution is added into a poor solvent to precipitate the polyamide resin. As the poor solvent, fluid hardly producing a solvate with the polyamide resin can be used without any particular limitation. Specific examples of the poor solvents include water, methanol, ethanol, and a mixed solvent thereof. The poor solvent is desirably used in a small amount as much as possible, in a range that the precipitated polyamide resin can be filtered without difficulties in operation, and is in the amount of preferably 0.5 to 50 parts by weight and particularly preferably 1 to 10 parts by weight, relative to 1 part by weight of the solvent used for the reaction.

Mixing of the washing-treated solution and the poor solvent can be carried out by gradually adding the poor solvent into the treated solution under stirring or the reaction solution into the poor solvent under stirring. Spraying the reaction solution into the poor solvent with a pump, with a compressor and two-fluid nozzle, or with a pump and one-fluid nozzle is preferred, since the aromatic polyamide resin having an appropriate particle diameter is easily precipitated. The temperature for mixing the reaction solution with the poor solvent is typically 0 to 100°C and preferably 20 to 80°C.

The aromatic polyamide resin precipitated after the mixing the reaction solution with the poor solvent is separated by filtration, and the cake of the separated aromatic polyamide resin is washed with water to remove ionic impurities. By drying the cake, the polyamide resin can be obtained. Ionic impurities can be removed further by additionally washing the cake with a water-soluble organic solvent.

Examples of the water-soluble organic solvents include alcohols such as methanol, ethanol, n-propanol and isopropanol, and acetone, and are used singly or in combination. Methanol is particularly preferred.

Washing with the water-soluble organic solvent is effective even when it is applied to the aromatic polyamide resin cake separated by the filtration and left on the filter. However, more excellent purification can be achieved by placing in a new container, together with the above water-soluble organic solvent, the separated polyamide resin cake containing the solvent and the poor solvent, or the polyamide resin of which cake is once dried to remove the solvent and the poor solvent, by suspending the cake under stirring, and by filtering the cake again. The amount of the water-soluble organic solvent to be used in this step is, relative to 1 part by weight of the net polyamide resin, 1 to 100 parts by weight and preferably 2 to 50 parts by weight. The stirring temperature is preferably from a room temperature to the boiling point of the suspension and particularly preferably the boiling point. The stirring is carried out for 0.1 to 24 hours and preferably 1 to 5 hours. Furthermore, the stirring is carried out at an ambient pressure, but can be carried out under a pressurized condition.

After the above suspension treatment, the aromatic polyamide resin is filtered, and usually the cake is additionally washed with the water-soluble organic solvent and thereafter optionally with water, and then dried to obtain the aimed aromatic polyamide resin with a less amount of ionic impurities.

The intrinsic viscosity (measured in an 0.5 g/dl N,N-dimethylacetamide solution at 30°C) of the aromatic polyamide resin to be used in the present invention is preferably 0.1 to 4.0 dl/g. Generally, whether the resin has a preferable average degree of polymerization or not is determined by referring to the intrinsic viscosity. An intrinsic viscosity smaller than 0.1 dl/g is not preferred because of poor film formation or poor exhibition of the properties for the aromatic polyamide resin. On the other hand, an intrinsic viscosity larger than 4.0 dl/g is too high in the degree of polymerization and gives rise to several problems such as poor solubility and poor capability of molding.

The values of m and n of the polyamide resin of the formula (1) thus obtained depends on the feed ratio of the aromatic dicarboxylic acid having no phenolic hydroxy group and the aromatic dicarboxylic acid having a phenolic hydroxy group. The ratio is typically 2 to 200 and preferably 5 to 150 in a average value.

According to the production process of the present invention, the resin layer can be obtained by removing the organic solvent from the varnish containing the aromatic polyamide resin, the epoxy resin and the organic solvent. The epoxy resin which can be used in this varnish is not critical as long as the epoxy resin has two or more epoxy groups in one molecule, and include, for example, a bisphenol A type epoxy resin, a bisphenol F type epoxy resin, a phenol novolac type resin, a cresol novolac type epoxy resin, a biphenol type epoxy resin, a triphenylmethane type epoxy resin, a biphenyl novolac type epoxy resin, and an alicyclic type epoxy resin. These may be used singly or in combination of two kinds or more.

The amount of the epoxy resin to be used in the varnish is preferably 0.5 to 1.5 equivalents relative to 1 equivalent of the active hydrogen of the aromatic polyamide resin. The active hydrogen equivalent of the aromatic polyamide resin can be calculated from the contents of amino groups of the molecular ends and phenolic hydroxy groups in the molecule. If the amount is less than 0.5 equivalent or more than 1.5 equivalent relative to 1 equivalent of the active hydrogen, curing would be incomplete and good physical properties of the cured material could not be obtained.

Also, the varnish can contain a curing accelerator. Examples of the curing accelerators which can be used include imidazoles such as 2-methylimidazole, 2-ethylimidazole, 2-ethyl-4-methylimidazole, 2-undecylimidazole, 2-heptadecylimidazole, 2-phenylimidazole, 2-phenyl-4-methylimidazole, 1-benzil-2-methylimidazole, 1-benzil-2-phenylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 2-phenyl-4,5-dihydroxymethylimidazole, and 2-phenyl-4-methyl-5-dihydroxymethylimidazole, tertiary amines such as 2-(dimethylaminomethyl)phenol and 1,8-diaza-bicyclo(5,4,0)undecene-7, phosphines such as triphenylphosphine, and metal compounds such as tin octylate. The curing accelerator of 0.01 to 5.0 parts by weight relative to 100 parts by weight of the aromatic polyamide resin is used if necessary.

The epoxy resin composition of the present invention can optionally contain an inorganic filler. Specific examples of the inorganic fillers used include silica, alumina, and talc. In the epoxy resin composition of the present invention, inorganic filler in an amount of 0 to 90% by weight is used. Furthermore, release agents such as a silane coupling agent, stearic acid, palmitic acid, zinc stearate and calcium stearate, and various compounding agents such as pigments can be added into the epoxy resin composition of the present invention.

The varnish used in the present invention is obtained by dissolving the epoxy resin and the aromatic polyamide resin described above in an organic solvent. Examples of the solvents to be used include amide solvents such as γ-butyrolactones, N-methylpyrrolidone (NMP), N,N-dimethylformamide (DMF), N,N-dimethylacetamide and N,N-dimethylimidazolidinone, sulfones such as tetramethylenesulfone, ether solvents such as diethylene glycol dimethyl ether, diethylene glycol diethyl ether, propylene glycol, propylene glycol monomethyl ether, propylene glycol monomethyl ether mono acetate and propylene glycol monobutyl ether, ketone solvents such as methyl ethyl ketone, methyl isobutyl ketone, cyclopentanone and cyclohexanone, and aromatic solvents such as toluene and xylene. The concentration of solid content (the concentration of components other than the solvent) contained in thus obtained varnish is typically 10 to 80% by weight and preferably 20 to 70% by weight.

In the present invention, in order to industrially form the resin layer on a metal foil, the above varnish is discharged from a film-forming slit onto the surface of the metal foil. The coating processes include processes using a roll coater, a comma coater, a knife coater, a doctor blade flow coater, and a sealing coater. For simple coating at a laboratory, an applicator can be used.

Thereafter, the organic solvent is removed by heating it at 60 to 180°C from the varnish applied on the metal foil. This process may be performed under reduced pressure or under infrared irradiation. After removing the solvent, a metal foil is applied onto the surface of the resin, and the resin layer is heated under an increased pressure at 150 to 250°C for 0.1 to 10 hours to cure the resin, obtaining the aimed double-sided flexible printed board. The thickness of the resin layer depends on the concentration of the solid content in the varnish to be coated, and is typically 2 to 200 µm and preferably 3 to 150 µm.

### Examples

Hereinafter, the present invention will be further explained specifically with Examples, in which "part" means "part by weight" unless otherwise noted.

### Synthetic Example 1

To a flask furnished with a thermometer, a cooling tube, a fractionating tube and a stirrer, under purging with nitrogen, 2.7 parts of 5-hydroxyisophthalic acid, 119.6 parts of isophthalic acid, 150 parts of 3, 4'-diamino diphenyl ether, 7.8 parts of lithium chloride, 811.5 parts of N-methylpyrrolidone, and 173.6 parts of pyridine were placed and stirred to dissolve them, and 376.2 parts of triphenyl phosphite were then added. The mixture was subjected to a condensation reaction at 95°C for 4 hours to obtain a reaction solution (A) of a polyamide resin. Into the reaction solution (A), 490 parts of water were dropped at 90°C for 2 hours and then was left at rest. After the reaction solution (A) was separated into an aqueous layer as an upper layer and an oil layer (resin layer) as a lower layer, the upper layer was removed by decantation. The amount of the discarded water was 1,100 parts. To the oil layer (resin layer), 610 parts of N,N-dimethylformamide was added and the oil layer was diluted. Thereafter, 245 parts of water was dropped at 90°C for 1 hour. The upper layer was removed by decantation. The amount of the discarded water was 1,100 parts. The above washing step was repeated 3 times to obtain 1,600 parts of a treated solution of an aromatic polyamide resin. This polyamide solution was dropped into 3,200 parts of stirred water using a dropping funnel, and particulates of the aromatic polyamide resin were precipitated and the precipitates were filtered. Thus obtained wet cakes were dispersed in 2,400 parts of methanol, and the dispersed solution was refluxed for 2 hours with stirring. The methanol was then removed by filtration. Thus obtained wet cakes were washed with 1,600 parts of water and dried to obtain 240 parts of the aromatic polyamide resin represented by the following formula (2).

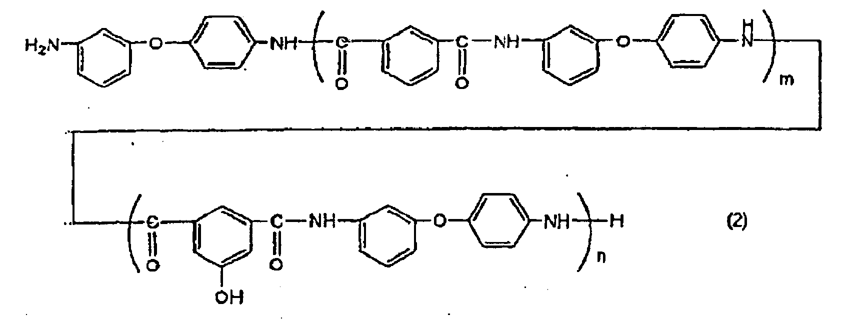

The total amount of phosphorus contained in this aromatic polyamide resin was wet-oxidatively decomposed with sulfuric acid and nitric acid, and was quantitated by molybdenum blue-ascorbic acid absorption photometry. The amount was 550 ppm. The intrinsic viscosity of the prepared aromatic polyamide resin was 0.52 dl/g (dimethylacetamide solution, 30°C), the value of m was about 39.2, and the value of n was about 0.8. The active hydrogen equivalent of the phenolic hydroxy-containing aromatic polyamide resin calculated from the feeding ratio relative to the epoxy group was about 5000 g/eq.

A varnish was prepared by using 7.50 parts of thus obtained aromatic polyamide resin, 0.42 parts of NC-3000 (manufactured by Nippon Kayaku Co., Ltd., epoxy equivalent: 275 g/eq, softening point: 55°C) as an epoxy resin, 0.01 parts of 2 PHZ-PW (manufactured by SHIKOKU CHEMICALS CORPORATION) as a curing catalyst, and 17 parts of N-methylpyrrolidone as a solvent, and by stirring and dissolving them.

### Test Example 1

The varnish prepared by the synthetic example 1 was applied in a thickness of 100 µm onto a rough surface of an electrolytic copper foil having a thickness of 18 µm using an applicator and was dried at 130°C for 30 minutes to remove the solvent. The varnish was then cured at 180°C for 1 hour obtaining a single-sided flexible board. No curling was observed at a room temperature after the curing.

No abnormal appearance was observed on the copper foil after boiling the single-sided flexible board for 30 minutes and then making the polyimide surface contact with a solder bath of 260°C for 30 seconds.

When the copper foil of thus obtained single-sided flexible board was removed by etching and the glass transition temperature of the resin layer was measured, the glass transition temperature was 235°C. When the noncombustibility was observed based on UL94 standard, the noncombustibility was V-0 level.

### Example 1

The varnish obtained in the synthetic example 1 was applied in a thickness of 100 µm onto a rough surface of an electrolytic copper foil having a thickness of 18 µm using an applicator and was dried at 130°C for 30 minutes to remove a solvent. An electrolytic copper foil having a thickness of 18 µm was then stuck on the surface of the resin, and the resin was cured at 180°C for 1 hour with pressurizing to 30 kg/cm² with a hot plate press, obtaining a double-sided flexible board.

The value of adhesion of thus obtained double-sided flexible board was measured by a copper foil peeling test based on JIS-C6471 standard, and was 2.1 kg/cm.

## Claims

1. A process for producing a double-sided flexible printed board comprising the steps of:
directly applying a varnish comprising an aromatic polyamide resin represented by the following formula (1), an epoxy resin, and an organic solvent to a metal foil,
removing the solvent to form a resin layer, and
applying another metal foil on the resin layer side and curing the resin layer, 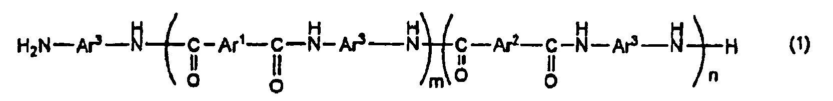 in the formula (1), m and n are average values, m+n is a positive number of 2 to 200, n is a positive number of 0.1 or larger;
Ar¹ is a divalent aromatic group;
Ar² is a divalent aromatic residue having a phenolic hydroxy group; and
Ar³ is selected from the group consisting of the formula (3) 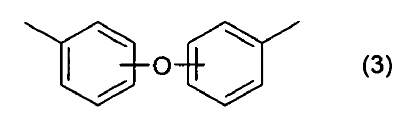 and the formula (4):

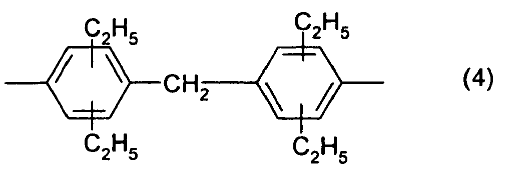

2. A double-sided flexible printed board consisting of three layers, wherein the three-layers consists of an insulating layer comprising an aromatic polyamide resin having a phenolic hydroxy group represented by the formula (1) in claim 1 and an epoxy resin, and metal foils provided on both sides of the insulating layer.

## Patentansprüche

1. Verfahren zur Herstellung einer doppelseitigen flexiblen Leiterplatte, umfassend die Schritte:
direktes Auftragen eines Lacks, der ein durch die folgende Formel (1) dargestelltes aromatisches Polyamidharz, ein Epoxyharz und ein organisches Lösungsmittel umfasst, auf eine Metallfolie,
Entfernen des Lösungsmittels zur Ausbildung einer Harzschicht, und
Anbringen einer weiteren Metallfolie auf der Harzschichtseite und Härten der Harzschicht, 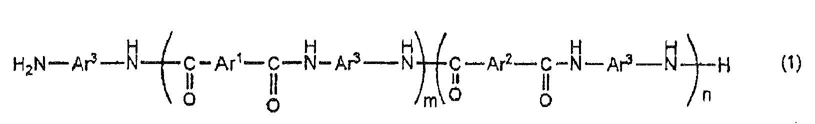 wobei in Formel (1) m und n Mittelwerte sind, m + n eine positive Zahl von 2 bis 200 ist, n eine positive Zahl von 0,1 oder größer ist;
Ar¹ eine divalente aromatische Gruppe ist;
Ar² ein divalenter aromatischer Rest ist, der eine phenolische Hydroxygruppe aufweist;
Ar³ ausgewählt wird aus der Gruppe, die aus Formel (3) 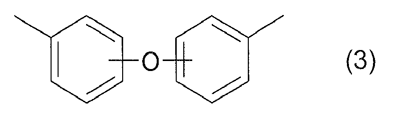 und Formel (4) besteht:

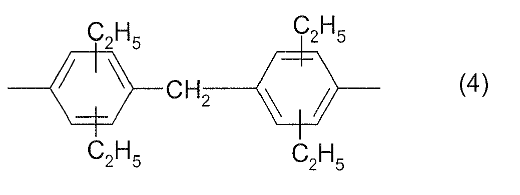

2. Doppelseitige flexible Leiterplatte, die aus drei Schichten besteht, wobei die drei Schichten aus einer isolierenden Schicht, welche ein aromatisches Polyamidharz, das eine phenolische Hydroxygruppe aufweist und durch Formel (1) in Anspruch 1 dargestellt wird, und ein Epoxyharz umfasst, und auf beiden Seiten der isolierenden Schicht vorgesehenen Metallfolien bestehen.

## Revendications

1. Procédé pour la production d'une carte de circuit imprimé souple à double face comprenant les étapes suivantes :
appliquer directement un vernis comprenant une résine de polyamide organique représentée par la formule suivante (1), une résine d'époxy et un solvant organique à une feuille métallique,
enlever le solvant pour former une couche de résine, et
appliquer une autre feuille métallique sur la côté de la couche de résine et durcir la couche de résine, 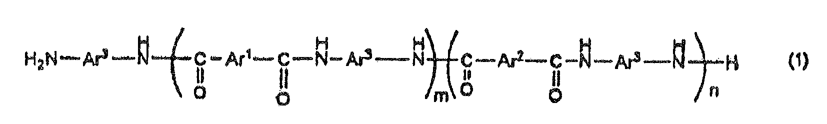
dans la formule (1), m et n sont des valeurs moyennes, m+n est un nombre positif de 2 à 200,
n est un nombre positif de 0,1 ou supérieur ;
Ar¹ est un groupe aromatique divalent ;
Ar² est un résidu aromatique divalent ayant un groupe hydroxy phénolique ; et
Ar³ est sélectionné parmi le groupe consistant en la formule (3) 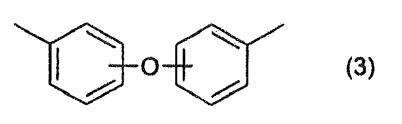 et la formule (4)

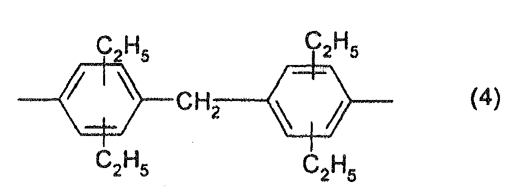

2. Carte de circuit imprimé souple à double face consistant en trois couches, dans laquelle les trois couches consistent en une couche isolante comprenant une résine de polyamide aromatique ayant un groupe hydroxy phénolique représenté par la formule (1) dans la revendication 1 et une résine d'époxy, et des feuilles métalliques fournies sur les deux côtés de la couche isolante.
